# EUROPEAN PATENT APPLICATION

(11) **EP 1 126 529 A2**
(43) Date of publication of application: **22.08.2001**
(21) Application number: 01830103.6
(22) Date of filing: 15.02.2001
(51) Int. Cl.: H01L 31/052, H01L 31/058, F24J 2/16, F24J 2/38

(54) **Solar and photovoltaic panel with energy regeneration and automatic sun tracking**

(30) Priority: 18.02.2000 IT LE000007
(71) Applicant: S.I.E.M. S.r.l., 73100 Lecce (IT)
(72) Inventor: Aguglia, Jorge Miguel, 73100 Lecce (IT); De Giorgi, Orlando, 73020 Acquarica Di Lecce (LE) (IT); Di Sansebastiano, Patrizia, 73100 Lecce (IT)

(57) **Abstract**

**-Summary**

The apparatus meant to be patented is a solar panel that exploits the combined energy of the photovoltaic and thermal systems to which is applied a concentrator equipped with a moving system that allows the automatic pursuit of the position of the sun. The ensemble of the two technologies allows an increase in output and a reduction in cost of produced energy.

## Description

### -Progress report

At present two kind of devices for the production of energy from the sun are available. One kind produces electric energy by means of photovoltaic panels, the other produces thermal energy either by heat transferring fluid panels or boilers warmed by the sun rays.

The photovoltaic system is made up of plates of semi conductor material of various shapes with different physical status (mono crystalline and poly crystalline).

The thermal system uses heat in order to warm (even over 2000° C) a fluid that can be used in several industrial processes or for the production of electricity.

Both systems though, must be positioned towards the sun and in order to achieve the best result they are generally firmly fixed southwards, with azimuth (inclination as regards the horizon), equal to the latitude of the place. For example, in Lecce at 40° 20' 52" North and 18° 07' 30" East, the panels will be inclined 40° southwards. By so doing, it is possible to exploit 66% approx. of what can be obtained by the automatic tracking.

At present there is no system on the market that melting the two technologies, together with concentration, produces low cost energy.

### -Description of the invention and Tables

The system is aimed at increasing the output of the photovoltaic panel by reducing the junction temperature by cooling, and by the fictitious increase of the picking up surface, by concentrating mirrors.

The system is made up of a photovoltaic panel (A) thermally coupled with a fluid panel (B) with the twofold aim of obtaining the cooling of photovoltaic cells and the warming of the fluid itself. The system completes itself by using concentrating even mirrors (C) able to increase the performance.

The warm fluid produced besides being used directly, can be exploited (where suitable) in pairing with thermal-electric conversion systems for the co-generation of electric energy.

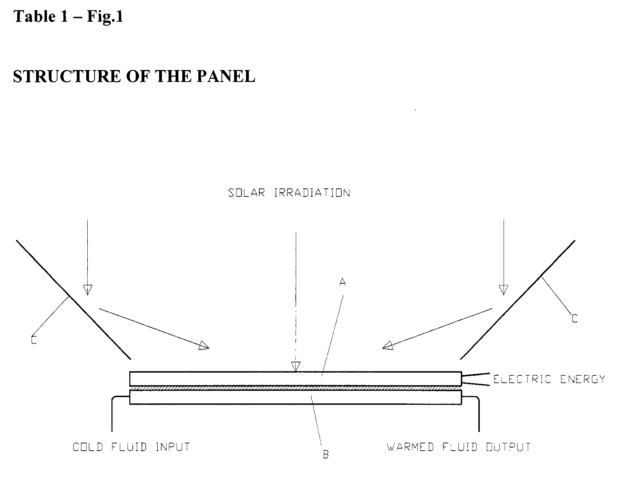

### STRUCTURE OF THE PANEL (See Table 1 - Fig. 1)

Complete system of sun generated energy.

The system is made up of the photovoltaic-solar panel and of:
- A mechanical structure made up of:
   1. supporting loom mounted on wheels
   2. engines for the rotation of the panels
   3. storing tank
   4. thermal-electric converter for the exploitation of the warmed fluid
- and of an electronic apparatus made up of:
   1. general lighting sensor:
      in order to decide the suitability of the moving of the panels in conditions of poor insolation
   2. solar positioning sensors:
      in order to locate the position of the sun
   3. temperature sensors
      for the control and qualification of the thermal generation
   4. general control circuit
   5. engines control circuit
   6. battery recharge circuit
      that depending on the irradiation conditions and on the position of the sun activates the engines in order to achieve the proper positioning of the solar panels and determines the qualification of the thermal station.

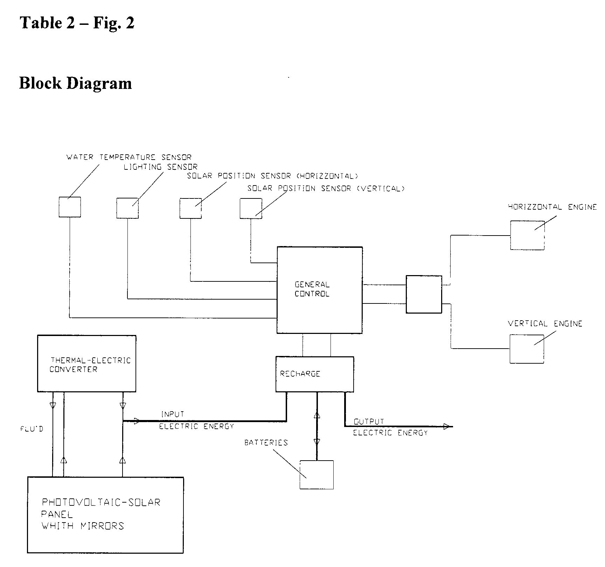

BLOCK DIAGRAM (See Table 2 - Fig. 2)

## Claims

1. Photovoltaic-thermal integrated panel

2. Concentrating system with mirrors

3. Automatic tracking system

4. System linkable together with a thermal-electric generator for the exploitation of the cooling fluid of
the photovoltaic cells

5. Cooled photovoltaic panel

6. Combined panel for the exploitation of the concentration of the sun rays

7. Solar panel with photovoltaic cells
